(19) Europäisches Patentamt
European Patent Office
Office européen des brevets

(11) **EP 3 812 063 A1**

(12) **EUROPEAN PATENT APPLICATION**
published in accordance with Art. 153(4) EPC

(43) Date of publication:
**28.04.2021 Bulletin 2021/17**

(21) Application number: **19824871.8**

(22) Date of filing: **24.06.2019**

(51) Int Cl.:
**B22F 1/00** *(2006.01)*          **B22F 7/04** *(2006.01)*
**H01B 1/22** *(2006.01)*          **H01L 21/52** *(2006.01)*

(86) International application number:
**PCT/JP2019/024989**

(87) International publication number:
**WO 2020/004342 (02.01.2020 Gazette 2020/01)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **25.06.2018   JP 2018119463
29.03.2019   JP 2019065363
20.06.2019   JP 2019114214**

(71) Applicant: **Mitsubishi Materials Corporation
Tokyo 100-8117 (JP)**

(72) Inventors:
• **NUMA Tatsuya**
  **Sanda-shi, Hyogo 669-1339 (JP)**
• **KATASE Takuma**
  **Sanda-shi, Hyogo 669-1339 (JP)**
• **YASOSHIMA Tsukasa**
  **Sanda-shi, Hyogo 669-1339 (JP)**
• **SAWADA Yoshinori**
  **Sanda-shi, Hyogo 669-1339 (JP)**
• **MASUYAMA Kotaro**
  **Naka-shi, Ibaraki 311-0102 (JP)**

(74) Representative: **Gille Hrabal
Partnerschaftsgesellschaft mbB
Patentanwälte
Brucknerstraße 20
40593 Düsseldorf (DE)**

(54) **SILVER PASTE AND JOINED BODY PRODUCTION METHOD**

(57)     This silver paste includes a silver powder, a fatty acid silver salt, and an aliphatic amine. The silver powder includes first silver particles having a particle size of 100 nm or more and less than 500 nm in an amount ranging from 55% by volume to 95% by volume, second silver particles having a particle size of 50 nm or more and less than 100 nm in an amount range of 5% by volume or more and 40% by volume or less, and third silver particles having a particle size of less than 50 nm in an amount of 5% by volume or less.

FIG. 1

EXAMPLE 15

SU70 3.0kV 3.0mm x10.0k SE(U)          5.00um
1 DIVISION: 5.00 μm

**Description**

TECHNICAL FIELD

The present invention relates to a silver paste that is used as a raw material for producing a joining layer for joining a circuit board and a high-power LED element, or a joining layer for joining a circuit board and a power semiconductor chip, and to a method for producing a joined body that is joined by a joining layer produced using this silver paste.
Priority is claimed on Japanese Patent Application No. 2018-119463, filed June 25, 2018; Japanese Patent Application No. 2019-065363, filed March 29, 2019; and Japanese Patent Application No. 2019-114214, filed June 20, 2019, the contents of which are incorporated herein by reference.

BACKGROUND ART

Conventionally, silver pastes each containing a silver powder, a thermosetting resin, and a solvent have been used for adhering and fixing (die bonding) a semiconductor chip to a metal plate such as a lead frame.
For example, the thermally conductive composition disclosed in Patent Document 1 includes a silver powder, fine silver particles, a fatty acid silver salt, an amine, and a silver resinate. The silver powder has an average particle size of 0.3 $\mu$m to 100 $\mu$m. The fine silver particles have an average primary particle size of 50 to 150 nm, a crystallite diameter of 20 to 50 nm, and a ratio of the average particle size to the crystallite diameter of 1 to 7.5.
It is considered that such a thermally conductive composition can provide a thermal conductor having a high thermal conductivity.

[Citation List]

[Patent Literature]

[Patent Document 1]
Japanese Patent No. 5872545 (see claim 1, paragraph [0006], and Fig. 1)

SUMMARY OF INVENTION

Technical Problem

However, in the thermally conductive composition disclosed in Patent Document 1, since a relatively large quantity of depletions (voids) are present in a thermal conductor produced using this thermally conductive composition as shown in Fig. 1 of Patent Document 1, there has been a problem that the heat conduction characteristics of the thermal conductor are low to that extent.
A first object of the present invention is to provide a silver paste with which a joining layer with fewer voids can be produced. A second object of the present invention is to provide a silver paste that can enhance the cooling-heating cycle characteristics of a joining layer produced using the silver paste. A third object of the present invention is to provide a silver paste with which operations such as coating can be facilitated by adjusting the viscosity of the silver paste. A fourth object of the present invention is to provide a silver paste that can enhance the heat conduction characteristics of a joining layer produced using the silver paste. A fifth object of the present invention is to provide a method for producing a joined body, by which the heat conduction characteristics and the cooling-heating cycle characteristics of a joined body by enhancing the heat conduction characteristics and the cooling-heating cycle characteristics of a joining layer.

Solution to Problem

The silver paste according to a first aspect of the present invention includes a silver powder, a fatty acid silver salt, and an aliphatic amine, wherein the silver powder includes first silver particles having a particle size of 100 nm or more and less than 500 nm in an amount ranging from 55% by volume to 95% by volume, includes second silver particles having a particle size of 50 nm or more and less than 100 nm in an amount range of 5% by volume or more and 40% by volume or less, and includes third silver particles having a particle size of less than 50 nm in an amount of 5% by volume or less.
A silver paste according to a second aspect of the present invention is an invention according to the first aspect and further includes a resin.
A silver paste according to a third aspect of the present invention is an invention according to the first or second aspect and further includes a solvent.

A silver paste according to a fourth aspect of the present invention is an invention according to any one of the first to third aspects and further includes a complex formed by a reaction between at least a portion of the fatty acid silver salt and at least a portion of the aliphatic amine.

A method for producing a joined body according to a fifth aspect of the present invention includes: a step of preparing a first member and a second member; a step of applying the silver paste according to any one of the first to fourth aspects on a surface of at least one of the first member and the second member and thereby forming a silver paste layer; a step of laminating the first member and the second member, with the silver paste layer interposed therebetween, and thereby producing a laminated body; and a step of heating the laminated body to sinter first silver particles, second silver particles, and third silver particles in the silver paste layer, thereby forming a joining layer, joining the first member and the second member, with the joining layer interposed therebetween, and thereby producing a joined body.

A method for producing a silver paste according to a sixth aspect of the present invention includes: a step of mixing a fatty acid silver salt, an aliphatic amine, and a solvent such that when a total amount of the fatty acid silver salt, the aliphatic amine, and the solvent is designated as 100% by mass, a proportion of the fatty acid silver salt is 0.1% by mass to 40% by mass, a proportion of the aliphatic amine is 0.1% by mass to 60% by mass, and a proportion of the solvent is 80% by mass or less, and thereby obtaining a mixture;

a step of heating the mixture to 30°C to 100°C, stirring the mixture, subsequently cooling the mixture, and thereby obtaining a mixed solution; and

a step of kneading the mixed solution and a silver powder, and thereby obtaining a silver paste,

wherein as the silver powder, a silver powder including: first silver particles having a particle size of 100 nm or more and less than 500 nm in an amount ranging from 55% by volume to 95% by volume, second silver particles having a particle size of 50 nm or more and less than 100 nm in an amount ranging from 5% by volume to 40% and third silver particles having a particle size of less than 50 nm in an amount of 5% by volume or less, is used. In the present specification, in a case in which the expression "A to B" is described, the expression means "A or more and B or less", except for a case in which there is a contradiction with other descriptions.

ADVANTAGEOUS EFFECTS OF INVENTION

In the silver paste according to the first aspect of the present invention, since the silver powder includes first silver particles having a particle size of 100 nm or more and less than 500 nm in an amount ranging from 55% by volume to 95% by volume, second silver particles having a particle size of 50 nm or more and less than 100 nm in an amount range of 5% by volume or more and 40% by volume or less, and third silver particles having a particle size of less than 50 nm in an amount of 5% by volume or less, the silver powder has a relatively broad particle size distribution. As a result, upon sintering, the gaps between the first silver particles, the second silver particles, and the third silver particles become small and compact, and therefore, a joining layer with fewer voids can be produced.

Since the silver paste according to the second aspect of the present invention further includes a resin, the cooling-heating cycle characteristics of a joining layer produced using the silver paste can be enhanced.

Since the silver paste according to the third aspect of the present invention further includes a solvent, an excellent effect that operations such as coating can be facilitated by adjusting the viscosity of the silver paste, is obtained.

Since the silver paste according to the fourth aspect of the present invention includes a complex formed by a reaction between at least a portion of the fatty acid silver salt and at least a portion of the aliphatic amine, fine silver is precipitated out from the complex during firing, and as this precipitated silver fills the spaces between the first silver particles, the second silver particles, and the third silver particles in the silver paste, a joining layer produced using the silver paste becomes more dense so that the heat conduction characteristics of the joining layer can be enhanced.

In the method for producing a joined body according to the fifth aspect of the present invention, a laminated body is produced by laminating a first member and a second member, with a silver paste layer obtained by applying the above-described silver paste interposed between the first member and the second member; first silver particles, second silver particles, and third silver particles in the silver paste layer are sintered by heating this laminated body, thereby a joining layer is formed; and a joined body in which the first member and the second member are joined by means of this joining layer is produced. Therefore, there are fewer voids in the joining layer, and the heat conduction characteristics and the cooling-heating cycle characteristics of the joined body produced by this method can be enhanced.

According to the method for producing a silver paste according to the sixth aspect of the present invention, it is possible to produce a silver paste with which a joining layer with fewer voids can be produced.

BRIEF DESCRIPTION OF DRAWINGS

Fig. 1 is an FE-SEM (Field Emission-Scanning Electron Microscope) photograph of a joining layer produced using a silver paste of Example 15.
Fig. 2 is an FE-SEM photograph of a joining layer produced using a silver paste of Example 16.
Fig. 3 is an FE-SEM photograph of a joining layer produced using a silver paste of Example 17.
Fig. 4 is an FE-SEM photograph of a joining layer produced using a silver paste of Comparative Example 3.

DESCRIPTION OF EMBODIMENTS

Next, embodiments of the present invention will be described.

A silver paste according to an embodiment of the present invention includes a silver powder, a fatty acid silver salt, and an aliphatic amine. The silver powder includes first silver particles (first group of silver particles), second silver particles (second group of silver particles), and third silver particles (third group of silver particles), which have mutually different particle sizes, and these first to third silver particles all aggregate with one another as primary particles and form aggregates (silver powder).

The first silver particles have a particle size of 100 nm or more and less than 500 nm and are included in an amount ranging from 55% by volume to 95% by volume when the total amount of the first silver particles, second silver particles, and third silver particles is designated as 100% by volume. The second silver particles have a particle size of 50 nm or more and less than 100 nm and are included in an amount range of 5% by volume or more and 40% by volume or less when the total amount of the first silver particles, second silver particles, and third silver particles is designated as 100% by volume. The third silver particles have a particle size of less than 50 nm and are included in an amount ranging from 5% by volume or less when the total amount of the first silver particles, second silver particles, and third silver particles is designated as 100% by volume. The "volume" as used herein indicates the volume of the silver particles themselves.

The amounts of the first, second, and third silver particles are limited to the above-described ranges, respectively, because as the silver powder formed by mixing these particles has a relatively broad particle size distribution, the silver powder forms dense aggregates with small gaps between the first, second, and third silver particles at the time of sintering, and thereby a joining layer having fewer voids can be produced. The purity of silver in the first, second, and third silver particles is preferably 90% by mass or higher, and more preferably 99% by mass or higher. This is because the first, second, and third silver particles having higher silver purity melt more easily, and therefore, the first, second, and third silver particles can be sintered at a relatively low temperature. Regarding elements other than silver in the first, second, and third silver particles, Au, Cu, Pd, and the like are acceptable.

It is more preferable that the first silver particles having a particle size of 100 nm or more and less than 500 nm are included in the silver powder in an amount ranging from 70% by volume to 90% by volume, it is more preferable that the second silver particles having a particle size of 50 nm or more and less than 100 nm are included in an amount ranging from 10% by volume to 30% by volume, and it is more preferable that the third silver particles having a particle size of less than 50 nm are included in an amount of 1% by volume or less. When the particle size distributions of the first, second, and third silver particles are the above-described ranges, the effect that dense aggregates having small gaps between the first, second, and third silver particles during sintering is enhanced, and a joining layer with even fewer voids can be produced.

The particle sizes of the first, second, and third silver particles can be each obtained by, for example, measuring a projected area of a silver particle in the silver powder using, for example, a SEM (Scanning Electron Microscope), calculating the equivalent circle diameter (diameter of a circle having the same area as the projected area of the silver particle) from the projected area thus obtained, and converting this calculated particle size into a particle size on a volume basis. A specific example of the measuring method will be described in Examples that will be described later.

It is preferable that the silver powder includes an organic material composed of an organic reducing agent or a decomposition product thereof, and it is preferable that this organic material is decomposed or volatilized at a temperature of 150°C. Examples of the organic reducing agent include ascorbic acid, formic acid, and tartaric acid. The organic material composed of an organic reducing agent or a decomposition product thereof has an effect of suppressing oxidation of the surfaces of the first, second, and third silver particles when the first, second, and third silver particles are stored in a state of aggregated secondary particles (that is, silver powder before being produced into a silver paste), and suppressing mutual diffusion, that is, diffusion joining during storage, of the first, second, and third silver particles. The organic material has an effect of being easily decomposed or volatilized when a silver paste including aggregates of silver particles is printed on a surface to be joined of a member as an object of joining and heated, thus exposing highly active surfaces of the first, second, and third silver particles, and thereby making a sintering reaction between the first, second, and third silver particles easier to proceed. Furthermore, a decomposition product or volatile matter of the organic material has a reducing ability of reducing an oxide film on the surfaces to be joined of a member as an object of joining.

When the organic material included in the silver powder remains in the joining layer, there is a risk that the organic material may be decomposed over time, causing voids to be generated in the joining layer. Therefore, it is preferable that the amount of the organic material in the silver powder is adjusted to 2% by mass or less with respect to 100% by mass of the total amount of the first, second, third silver particles. However, in order to obtain the above-described effects brought by the organic material, it is preferable that the amount of the organic material is 0.05% by mass or more with respect to 100% by mass of the total amount of the first, second, and third silver particles. The amount of the organic material is more preferably 0.1% to 1.5% by mass with respect to 100% by mass of the total amount of the first, second, and third silver particles.

According to the present invention, the silver powder before being mixed with the various components that will be described below is in a state of secondary particles in which first, second, and third silver particles (primary particles) have aggregated, and in a volume-based particle size distribution curve that is measured by a laser diffraction scattering method, it is preferable that D10 is in a range of from 0.05 μm to 0.25 μm, D50 is in a range of from 0.4 μm to 0.6 μm, and D90 is in a range of from 1.5 μm to 2.5 μm. In the silver paste of the present invention obtainable from a silver powder having such a relatively wide particle size distribution and the various components that will be described below, the effect that dense aggregates with small gaps between the first, second, and third silver particles can be formed at the time of sintering is enhanced, and a joining layer with even fewer voids can be produced.

Measurement of a volume-based particle size distribution according to a laser diffraction scattering method is carried out as follows. First, 0.1 g of a silver powder (secondary particles) was introduced into 20 g of ion-exchanged water, the resulting mixture was irradiated with ultrasonic waves at 25 kHz for 5 minutes, and thereby the silver powder was uniformly dispersed in the ion-exchanged water. Next, an appropriate amount of a dispersion liquid of silver powder thus obtained was dropped into an observation cell of a laser diffraction scattering type particle size distribution analyzer (manufactured by Horiba, Ltd., trade name "LA-960"), and the particle size distribution was measured according to the procedure for this device. The particle size distribution measured by this laser diffraction scattering method is a particle size distribution of secondary particles in which first, second, and third silver particles (primary particles) have aggregated.

It is preferable for the aggregates of the first, second, and third silver particles that the specific surface area is in a range of 2 $m^2/g$ to 8 $m^2/g$, and more preferably in a range of 3 $m^2/g$ to 7 $m^2/g$. Since aggregates having a specific surface area within the above-described range have large reaction areas of the first, second, and third silver particles, and the reactivity is increased by heating, the aggregates can be sintered at a relatively low temperature.

Examples of the fatty acid silver salt include silver acetate, silver oxalate, silver propionate, silver myristate, and silver butyrate. Examples of the aliphatic amine include primary amines, secondary amines, and tertiary amines. It is desirable that the carbon number of the aliphatic amine is preferably adjusted to 8 to 12. When the carbon number is too small, the boiling point of the aliphatic amine tends to be low, and therefore there is a risk that the printability of the silver paste may be deteriorated. When the carbon number is too large, sintering of the silver particles in the silver paste may be hindered, and there is a risk that a joined body having sufficient strength may not be obtained.

Specific examples include, as primary amines, ethylhexylamine, aminodecane, dodecylamine, nonylamine, and hexylamine; as secondary amines, dimethylamine and diethylamine; and as tertiary amines, trimethylamine and triethylamine.

With regard to the silver paste, the molar ratio of the aliphatic amine to the fatty acid silver salt, that is, the ratio of molar amount of the aliphatic amine/molar amount of the fatty acid silver salt, may be in a range of 1.5 to 3. When the proportion of the aliphatic amine is small, the proportion of the fatty acid silver salt, which is a solid, becomes relatively high, and therefore, it is difficult for the silver powder to be uniformly dispersed in the silver paste, while there is a risk that voids may be easily produced inside the joining layer obtained by heating. When the proportion of the aliphatic amine is too large, an excess amount of the aliphatic amine causes grain growth of the silver powder in the silver paste, and since the paste viscosity decreases, there is a risk that the printability may be deteriorated. The ratio of molar amount of the aliphatic amine/molar amount of the fatty acid silver salt may be preferably in a range of 1.7 to 2.8 and may be more preferably in a range of 2.0 to 2.5.

It is preferable that the silver paste includes a complex that is formed by a reaction between at least a portion of the fatty acid silver salt and at least a portion of the aliphatic amine. This complex is presumed to be a silver-amine complex.

It is preferable that the silver paste further includes any one or both of a resin or a solvent. Examples of the resin include an epoxy resin, a silicone resin, an acrylic resin, and mixtures thereof. Examples of the epoxy resin include a bisphenol A type epoxy resin, a novolac type epoxy resin, a cycloaliphatic epoxy resin, and mixtures thereof; examples of the silicone type resin include a methylsilicone resin, an epoxy-modified silicone resin, a polyester-modified silicone resin, and mixtures thereof; and examples of the acrylic resin include an acrylate-based monomer resin. These resins are cured by heating of the silver paste, and the cured body fills the voids of a sintered body of the silver powder. As the voids of the sintered body of the silver powder are filled with a cured body of the thermosetting resin composition, the mechanical strength of the joining layer is enhanced, and furthermore, a decrease in the joining strength under the load of cooling/heating cycle is suppressed.

The amount of the resin may be in a range of 0.1% by mass or more and 3% by mass or less when the total amount of the silver paste is designated as 100% by mass. When the amount of the resin is less than 0.1% by mass, there is a risk that the mechanical strength of the joining layer may not be enhanced, and when the amount is more than 3% by mass, there is a risk that the mechanical strength of the joining layer that may hinder the sintering of the silver powder may be decreased. The amount of the resin may be preferably in a range of 0.2% to 2.5% by mass, and may be more preferably in a range of 0.3% to 2.0% by mass, when the amount of the silver paste is designated as 100% by mass.

Examples of the solvent include an alcohol-based solvent, a glycol-based solvent, an acetate-based solvent, a hydrocarbon-based solvent, and mixtures thereof. Examples of the alcohol-based solvents include α-terpineol, isopropyl alcohol, ethylhexanediol, and mixtures thereof; examples of the glycol-based solvents include ethylene glycol, diethylene glycol, polyethylene glycol, and mixtures thereof; examples of the acetate-based solvent include butyl carbitol acetate; and examples of the hydrocarbon-based solvent include decane, dodecane, tetradecane, and mixtures thereof.

A specific example of the method for producing a silver paste will be described. First, a fatty acid silver salt, an aliphatic amine, and a solvent are prepared and mixed such that when the total amount of the fatty acid silver salt, the aliphatic amine, and the solvent is designated as 100% by mass, for example, the proportion of the fatty acid silver salt is 0.1% by mass to 40% by mass, the proportion of the aliphatic amine is 0.1% by mass to 60% by mass, and the proportion of the solvent is 80% by mass or less. The reason why the mixing proportions of the fatty acid silver salt, the aliphatic amine, and the solvent are desired to be within the above-described ranges is that the effects of the present invention can be obtained without causing precipitation or the like in the mixed liquid. More preferably, when the total amount of the fatty acid silver salt, the aliphatic amine, and the solvent is designated as 100% by mass, the fatty acid silver salt is mixed at a proportion of 20% by mass to 30% by mass, the aliphatic amine at a proportion of 20% by mass to 40% by mass, and the solvent at a proportion of 40% by mass to 60% by mass.

Next, the mixture is heated to 30°C to 100°C and stirred for 5 minutes to 10 hours, thereby a mixed liquid is prepared, and then this mixed liquid is cooled to room temperature (25°C). Thereby, a mixed solution of the fatty acid silver salt, the aliphatic amine, and the solvent (simply referred to as mixed solution) is prepared. The heating temperature and the heating time of the mixture are set within the above-described ranges in order to uniformly mix the fatty acid silver salt, the aliphatic amine, and the solvent. The solvent is not necessarily required. For example, in a case in which the aliphatic amine is liquid at room temperature, it is also possible to produce a mixed liquid by mixing the fatty acid silver salt and the aliphatic amine without using a solvent.

Next, after the mixed solution and the silver powder are kneaded, the mixture is stirred with a planetary planetary stirrer or the like and is further kneaded by a three-roll mill or the like, and thereby a silver paste is obtained. When the amount of the silver paste is designated as 100% by mass, the amount of the silver powder may be in a range of 50% by mass to 95% by mass, while the balance is the mixed solution. Preferably, the amount of the silver powder may be 80% by mass to 90% by mass. In the silver paste, when the amount of the silver powder is small, there is a risk that the viscosity of the silver paste may be lowered, and coating defects such as sagging may easily occur. When the content is too high, there is a risk that the viscosity may increase, and the handleability may be deteriorated. The silver paste may not include the solvent. The silver paste may include the resin. In this case, the cooling-heating cycle characteristics are enhanced.

With regard to the mixed solution, the molar ratio of the aliphatic amine to the fatty acid silver salt, that is, the ratio of molar amount of the aliphatic amine/molar amount of the fatty acid silver salt, is preferably adjusted to be in a range of 1.5 to 3, and more preferably to be in a range of 1.7 to 2.8. When a silver paste is produced using such a mixed solution, the molar ratio of the aliphatic amine to the fatty acid silver salt in the mixed solution becomes the molar ratio of the aliphatic amine to the fatty acid silver salt in the silver paste.

A procedure for producing a joined body using the silver paste will be described. First, a first member and a second member to be joined together are prepared. The first member may be, for example, a Si wafer having the outermost surface plated with gold, and the second member may be, for example, a Cu plate having the outermost surface plated with silver. However, the members are not limited to these.

Next, the silver paste is applied on the surface of the first member and/or the second member by, for example, a metal mask method or the like, and thereby a silver paste layer having a desired planar shape is formed. Next, the first member and the second member are laminated, with the silver paste layer interposed therebetween, and a laminated body is produced. Then, this laminated body is fired, that is, the laminated body is heated and maintained at a temperature (heating temperature) of 120°C to 280°C for 10 minutes to 240 minutes (heating time), thereby first silver particles, second silver particles, and third silver particles in the silver paste layer are sintered to form a joining layer, and a joined body in which the first member and the second member are joined by means of this joining layer is produced.

The heating temperature and the heating time of the laminated body are set to be in the above-described ranges because when the heating time is less than 10 minutes, there is a risk that it may be difficult for sintering to proceed, and even when the heating time exceeds 240 minutes, the cost increases without any change in the joining characteristics. It is preferable that the laminated body is produced by heating only without applying pressure. This because the process is simplified and the cost is reduced.

EXAMPLES

Next, Examples of the present invention will be described in detail together with Comparative Examples.

<Example 1>

First, silver acetate (fatty acid silver salt), aminodecane (aliphatic amine) and butyl carbitol acetate (solvent) were prepared, and when the total amount of the fatty acid silver salt, the aliphatic amine, and the solvent was designated as 100% by mass, silver acetate (fatty acid silver salt) was apportioned at a proportion of 22% by mass, aminodecane (aliphatic amine) at a proportion of 41.3% by mass, and butyl carbitol acetate (solvent) at a proportion of 36.7% by mass. These were placed in a glass container together with a stirring bar of a stirrer. Then, the container was mounted on a hot plate that had been heated to 50°C, the mixture was stirred for one hour while the stirring bar of the stirrer was rotated at 300 rpm, and a mixed liquid was prepared. Next, the container storing the mixed liquid was removed from the hot plate, and the temperature of the mixed liquid was lowered to room temperature. Thereby, a fatty acid silver salt/aliphatic amine mixed solution (hereinafter, simply referred to as mixed solution) was prepared. This mixed solution was referred to as Example 1.

<Examples 2 to 14 and Comparative Examples 1 and 2>

Regarding the mixed solutions of Examples 2 to 14 and Comparative Examples 1 and 2, the compounds of the types shown in Table 1 were used as the fatty acid silver salt, the aliphatic amine, and the solvent, and the fatty acid silver salt, the aliphatic amine, and the solvent were mixed at the respective proportions shown in Table 1. Since Comparative Example 1 did not include a fatty acid silver salt and Comparative Example 2 did not include an aliphatic amine, those were not mixed solutions; however, in the present specification, Comparative Examples 1 and 2 will also be referred to as mixed solutions for convenience.

In the column for the type of the fatty acid silver salt in Table 1, "A1" represents silver acetate, "A2" represents silver oxalate, and "A3" represents silver myristate. In the column for the type of the aliphatic amine in Table 1, "B1" represents aminodecane, "B2" represents hexylamine, "B3" represents nonylamine, and "B4" represents dodecylamine. Furthermore, in the column for the type of the solvent in Table 1, "C1" represents butyl carbitol acetate, "C2" represents ethylene glycol, "C3" represents terpineol, and "C4" represents 2-ethyl-1,3-hexanediol.

[Table 1]

| | Fatty acid silver salt | | Aliphatic amine | | Molar ratio(aliphatic amine/fatty acid silver salt) | Solvent | |
| | Type | Mixing amount(parts by mass) | Type | Mixing amount (parts by mass ) | | Type | Mixing amount (parts by mass ) |
|---|---|---|---|---|---|---|---|
| Example 1 | A1 | 22.0 | B1 | 41.3 | 2 | C1 | 36.7 |
| Example 2 | A1 | 13.2 | B1 | 24.8 | 2 | C1 | 62.0 |
| Example 3 | A1 | 16.5 | B1 | 31.0 | 2 | C1 | 52.5 |
| Example 4 | A1 | 33.0 | B1 | 62.0 | 2 | C1 | 5.0 |
| Example 5 | A1 | 22.0 | B1 | 30.7 | 1.5 | C1 | 47.3 |
| Example 6 | A1 | 22.0 | B1 | 62.0 | 3 | C1 | 16.0 |
| Example 7 | A1 | 22.0 | B2 | 26.7 | 2 | C1 | 51.3 |
| Example 8 | A1 | 22.0 | B3 | 37.3 | 2 | C1 | 40.7 |
| Example 9 | A1 | 22.0 | B4 | 48.7 | 2 | C1 | 29.3 |
| Example 10 | A2 | 22.0 | B1 | 22.7 | 2 | C1 | 55.3 |
| Example 11 | A3 | 22.0 | B1 | 20.7 | 2 | C1 | 57.3 |
| Example 12 | A1 | 13.2 | B1 | 24.8 | 2 | C2 | 62.0 |
| Example 13 | A1 | 13.2 | B1 | 24.8 | 2 | C3 | 62.0 |
| Example 14 | A1 | 13.2 | B1 | 24.8 | 2 | C4 | 62.0 |

(continued)

|  | Fatty acid silver salt | | Aliphatic amine | | Molar ratio(aliphatic amine/fatty acid silver salt) | Solvent | |
|---|---|---|---|---|---|---|---|
|  | Type | Mixing amount(parts by mass) | Type | Mixing amount (parts by mass ) |  | Type | Mixing amount (parts by mass ) |
| Comparative Example 1 | None | 0 | B1 | 41.3 | - | C1 | 58.7 |
| Comparative Example 2 | A1 | 22.0 | None | 0 | - | C1 | 78.0 |

<Comparison Test 1 and evaluation>

The mixed solutions of Examples 1 to 14 and Comparative Examples 1 and 2 were heated to 130°C for 10 minutes while being stirred, 1 g of this mixed solution was dropped on a silicon wafer and dried under reduced pressure at a temperature of 25°C, and thereby a wafer having the dried matter attached to the surface was produced. Then, the surface of this wafer was observed by SEM (scanning electron microscopy), 1,000 particles attached to the surface were counted, and projected areas of the extracted particles (primary particles) were measured using an image processing software program (Image-J (National Institutes of Health: development)). The equivalent circle diameters were calculated from the projected areas thus obtained, and these were designated as primary particle sizes. The equivalent circle diameter was not measured for particles where the contour was not visually recognizable. The primary particle sizes thus obtained were converted into volume-based particle sizes, and the average value of the volume-based particle sizes was designated as average particle size of the dried matter. A sample in which a silver powder was generated from the dried matter was determined as "acceptable", and a sample in which a silver powder was not generated from the dried matter, or a sample in which a silver powder could not be measured was determined as "unacceptable". The average particle size of the dried matter and the determination results are presented in Table 2. Table 2 also shows the types of the fatty acid silver salt, the types of the aliphatic amine, and the types of the solvent.

[Table 2]

|  | Fatty acid silver salt Type | Aliphatic amine Type | Solvent Type | Average particle size of dried matter(nm) | Determination results |
|---|---|---|---|---|---|
| Example 1 | A1 | B1 | C1 | 60 | Acceptable |
| Example 2 | A1 | B1 | C1 | 60 | Acceptable |
| Example 3 | A1 | B1 | C1 | 60 | Acceptable |
| Example 4 | A1 | B1 | C1 | 60 | Acceptable |
| Example 5 | A1 | B1 | C1 | 70 | Acceptable |
| Example 6 | A1 | B1 | C1 | 40 | Acceptable |
| Example 7 | A1 | B2 | C1 | 100 | Acceptable |
| Example 8 | A1 | B3 | C1 | 60 | Acceptable |
| Example 9 | A1 | B4 | C1 | 40 | Acceptable |
| Example 10 | A2 | B1 | C1 | 60 | Acceptable |
| Example 11 | A3 | B1 | C1 | 50 | Acceptable |
| Example 12 | A1 | B1 | C2 | 60 | Acceptable |
| Example 13 | A1 | B1 | C3 | 40 | Acceptable |
| Example 14 | A1 | B1 | C4 | 50 | Acceptable |
| Comparative Example 1 | None | B1 | C1 | Not generated | Unacceptable |

(continued)

|  | Fatty acid silver salt Type | Aliphatic amine Type | Solvent Type | Average particle size of dried matter(nm) | Determination results |
|---|---|---|---|---|---|
| Comparative Example 2 | A1 | None | C1 | Undetectable | Unacceptable |

As is obvious from Table 2, in the mixed solution of Comparative Example 1 that did not include a fatty acid silver salt, silver that is expected to contribute to densification of the joining layer was not included, and therefore, the generation of a silver powder was not observed during SEM (scanning electron microscopy) observation. Thus, the determination results were rated as unacceptable.

In the mixed solution of Comparative Example 2 that did not include an aliphatic amine, a uniform mixed solution was not obtained, and the dried matter on the silicon wafer became lumps. Therefore, a silver powder could not be measured by SEM (scanning electron microscopy) observation, and the determination results were rated as unacceptable. This is speculated to be because Comparative Example 2 did not include an aliphatic amine, and therefore decomposition of the fatty acid silver salt did not sufficiently proceed.

In contrast to these, in the mixed solutions of Examples 1 to 14 that included a fatty acid silver salt and an aliphatic amine, generation of a silver powder having an average particle size of 50 nm to 100 nm was observed during SEM (scanning electron microscopy) observation, and the determination results were rated as acceptable. This is speculated to be because since Examples 1 to 14 included fatty acid silver salt and an aliphatic amine, the organic material was rapidly decomposed by heating, and silver nanoparticles having a highly active surface exposed were easily formed.

<Example 15>

In order to make the amount of the silver paste 100% by mass, 25% by mass of the mixed solution of Example 1 and 75% by mass of a silver powder (aggregates of first, second, and third silver particles) were kneaded and then stirred with a planetary planetary stirrer, and the resultant was further kneaded with a three-roll mill. Thereby, a silver paste was obtained. This silver paste was used as Example 15.

The silver powder (mixture/aggregates of first to third silver particles) of No. 1 shown in Table 5 was prepared as follows. First, fine silver particles in which the D10, D50, and D90 were 20 nm, 50 nm, and 100 nm, and fine silver particles in which the D10, D50, and D90 were 150 nm, 300 nm, and 500 nm, were prepared. The D10, D50, and D90 of the fine silver particles were determined from a particle size distribution curve of the fine silver particles. The particle size distribution curve of the fine silver particles was measured by a dynamic light scattering method that will be described below. The fine silver particles in which the D10, D50, and D90 were 20 nm, 50 nm, and 100 nm, respectively (raw material powder A), and the fine silver particles in which the D10, D50, and D90 were 150 nm, 300 nm, and 500 nm, respectively (raw material powder B), thus prepared were mixed at proportions that gave a mass ratio of 1:3, and a fine silver particle mixture was obtained.

Raw material powders A and B can be produced as follows. Regarding the raw material powder A, for example, silver nitrate, citric acid, and potassium hydroxide are mixed in distilled water at an equimolar ratio (1:1:1) with respect to silver ions in silver nitrate, and thereby a suspension is produced. Hydrazine acetate is added to this suspension at a molar ratio of 2 to 1 of silver ions. The raw material powder A can be obtained by causing the suspension, to which hydrazine acetate has been added, to react at a liquid temperature of 40°C, and subjecting the resulting reaction liquid slurry to washing, collecting, and drying.

The raw material powder B is obtained by, for example, mixing an aqueous solution of silver nitrate, aqueous ammonia, and distilled water, preparing an aqueous solution of silver ammine having a silver concentration of 22 g/L, adding a reducing solution to this aqueous solution of silver ammine, and subjecting a silver particle slurry thus produced to washing, collecting, and drying. The reducing solution is a mixed solution of an aqueous solution of hydroquinone and an aqueous solution of sodium hydroxide, and is a liquid in which an oxidation-reduction potential has been adjusted to -380 mV based on Ag/AgCl.

<Method for measuring particle size distribution curve by dynamic light scattering method>

First, 0.1 g of fine silver particles were introduced into 20 g of ion-exchanged water, the resulting mixture was irradiated with ultrasonic waves at 25 kHz for 5 minutes, and thereby the fine silver particles were dispersed in the ion-exchanged water. Next, the dispersion liquid of fine silver particles thus obtained was poured into an observation cell for a dynamic light scattering type particle size distribution analyzer (Horiba, Ltd., trade name "LB-550"), and the particle size distribution was measured according to the procedure of this apparatus.

The fine silver particle mixture, sodium ascorbate (organic reducing agent), and water were mixed at proportions that gave a mass ratio of 10:1:89, and a fine silver particle slurry was prepared. This fine silver particle slurry was heated at a temperature of 90°C for 3 hours, and thereby the fine silver particles were subjected to a reduction treatment. Next, the fine silver particle slurry was allowed to cool naturally to room temperature, and then solid matter was separated and collected using a centrifuge. This solid matter thus collected (mercury-containing fine silver particle aggregates) was washed with water several times and dried, and silver powder No. 1 (mixture of first, second, and third silver particles) as shown in Table 5 was obtained.

Silver powder No. 2 was obtained similarly by a method for preparing silver powder No. 2, except that the mixing proportions of the silver particles having a D50 of 50 nm and the silver particles having a D50 of 300 nm in the above-described method for preparing silver powder No. 1 were changed to a mass ratio of 1:1.

Silver powder No. 3 was obtained similarly by a method for preparing silver powder No. 3, except that the mixing proportions of the silver particles having a D50 of 50 nm and the silver particles having a D50 of 300 nm in the above-described method for preparing silver powder No. 1 were changed to a mass ratio of 1:5.

Silver powder No. 4 was obtained by the following method. To 1,200 g of ion-exchanged water maintained at 50°C, 900 g of an aqueous solution of silver nitrate maintained at 50°C and 600 g of an aqueous solution of sodium citrate maintained at 50°C were simultaneously added dropwise over 5 minutes, and a silver citrate slurry was prepared. The ion-exchanged water was continuously stirred while the aqueous solution of silver nitrate and the aqueous solution of sodium citrate were simultaneously added dropwise to the ion-exchanged water. Furthermore, the concentration of silver nitrate in the aqueous solution of silver nitrate was 66% by mass, and the concentration of citric acid in the aqueous solution of sodium citrate was 56% by mass. Next, to the silver citrate slurry maintained at 50°C, 300 g of an aqueous solution of sodium formate maintained at 50°C was added dropwise over 30 minutes, and a mixed slurry was obtained. The concentration of formic acid in this aqueous solution of sodium formate was 58% by mass.

Next, the mixed slurry was subjected to a predetermined heat treatment. Specifically, the mixed slurry was heated to a maximum temperature of 60°C at a rate of temperature increase of 10°C/hour, was maintained at 60°C (maximum temperature) for 30 minutes, and then was cooled to 20°C over 60 minutes. Thereby, a silver powder slurry was obtained. The silver powder slurry was placed in a centrifuge and was rotated for 10 minutes at a speed of rotation of 1,000 rpm. Thereby, the liquid layer in the silver powder slurry was removed, and a dehydrated and desalted silver powder slurry was obtained. This dehydrated and desalted silver powder slurry was dried for 30 hours by the freeze-drying method, and thus silver powder No. 4 was obtained.

Silver powder No. 5 was obtained similarly by a method for preparing silver powder No. 5, except that the mixing proportions of the silver particles having a D50 of 50 nm and the silver particles having a D50 of 300 nm in the above-described method for preparing silver powder No. 1 were changed to a mass ratio of 2:1.

Silver powder No. 6 was obtained similarly by a method for preparing silver powder No. 6, except that the mixing proportions of the silver particles having a D50 of 50 nm and the silver particles having a D50 of 300 nm in the above-described method for preparing silver powder No. 1 were changed to a mass ratio of 1:6.

Silver powder No. 7 was obtained similarly by a method for preparing silver powder No. 7, except that the mixing proportions of the silver particles having a D50 of 50 nm and the silver particles having a D50 of 300 nm in the above-described method for preparing silver powder No. 1 were changed to a mass ratio of 2:9.

Silver powder No. 8 was obtained similarly by a method for preparing silver powder No. 8, except that only the silver particles having a D50 of 50 nm were used in the above-described method for preparing silver powder No. 1, were used.

Silver powder No. 9 was obtained similarly by a method for preparing silver powder No. 9, except that the mixing proportions of the silver particles having a D50 of 50 nm and the silver particles having a D50 of 300 nm in the above-described method for preparing silver powder No. 1 were changed to a mass ratio of 4:3.

Silver powder No. 10 was obtained similarly by a method for preparing silver powder No. 10, except that the mixing proportions of the silver particles having a D50 of 50 nm and the silver particles having a D50 of 300 nm in the above-described method for preparing silver powder No. 1 were changed to a mass ratio of 1:9.

With regard to the silver powders thus obtained, the particle size distribution of the silver particles (first, second, and third silver particles) constituting a silver powder, and the amount of organic material included in a silver powder were respectively measured by the following methods.

<Method for measuring particle size distribution of silver particles>

Five hundred images of aggregates (secondary particles) in which first, second, and third silver particles were aggregated were acquired using SEM, and the particle sizes of the silver particles (primary particles) included in each aggregate were measured. At this time, the apparatus magnification for SEM was 100,000 times. From the 500 SEM images of aggregates, silver particles from which the entire outline of a silver particle (primary particle) could be visually recognized, were extracted. Next, the projected areas of the extracted silver particles were measured using an image processing software program (Image-J), the equivalent circle diameters were calculated from the projected areas thus obtained, and these were designated as the particle sizes of the silver particles. The equivalent circle diameter was not measured for silver particles having a site where the contour could not be visually recognized. The particle sizes of the silver particles thus obtained were converted into volume-based particle sizes, and a particle size distribution of the volume-based particle sizes was determined. The results are presented in Table 5.

<Method for measuring amount of organic material>

A silver powder was weighed out and was heated in an air atmosphere at a temperature of 150°C for 30 minutes. After heating, the silver powder was allowed to cool naturally to room temperature, and the mass of the silver powder was measured. The amount of an organic material was calculated from the following Formula (1). As a result, the amount of organic material was 0.2% by mass.

$$\text{Amount of organic material (mass\%)} = \{(A - B) / A\} \times 100 \quad \text{........} \quad (1)$$

However, A in Formula (1) represents the mass of the silver powder before heating, and B represents the mass of the silver powder after heating. The results thus obtained are presented in Table 5.

<Examples 16 to 33 and Comparative Examples 3 to 8>

Regarding the silver pastes of Examples 16 to 33 and Comparative Examples 3 to 8, each of the silver pastes was prepared by using the fatty acid silver salt, the aliphatic amine, and the solvent of the types shown in Table 1 as the mixed solution, mixing the silver powder and the mixed solution at the respective proportions shown in Tables 3 and 4, and carrying out the production process in the same manner as in Example 15 except for the formulations shown in Table 3 and Table 4. The mixed solutions used in Examples 15 to 33 and Comparative Examples 3 to 8 are shown in any one of Examples 1 to 14 in the column for the type of the mixed solution in Tables 3 and 4. In Examples 15 to 33 and Comparative Examples 3 to 8, any one of 12 kinds (No. 1 to No. 10) of silver powders having different particle size distributions as shown in Table 5 was incorporated, and the silver powders used in Examples 15 to 33 and Comparative Examples 3 to 8 are shown in any one of No. 1 to No. 10 in the column for the type of the silver powder in Table 3 and Table 4.

<Comparison Test 2 and evaluation>

(1) Joined bodies were prepared using the silver pastes of Examples 15 to 33 and Comparative Examples 3 to 8. Specifically, first, a Si wafer (thickness: 200 $\mu$m) that measured 2.5 mm on each of four sides and had the outermost surface plated with gold was prepared as a first member, and a Cu plate (thickness: 1 mm) that measured 20 mm on each of four sides and had the outermost surface plated with silver was prepared. A square Cu plate (thickness: 1 mm) was prepared as a second member. Next, the silver paste was applied on the surface of the second member by a metal mask method, and thus a silver paste layer was formed. Next, the first member was mounted on the silver paste layer, and thereby a laminated body was produced. Furthermore, the first member and the second member were joined, with the joining layer interposed therebetween, by firing this laminated body, that is, by maintaining the laminated body at a temperature (heating temperature) of 150°C for 60 minutes (heating time). These joined bodies were used as the joined bodies of Examples 15 to 33 and Comparative Examples 3 to 8. The laminated bodies were not pressed. The joining strength of these joined bodies was measured as follows.

(1-1) Method for measuring joining strength of joined body

The joining strength of the joined bodies of Examples 15 to 33 and Comparative Examples 3 to 8 was measured using a shear strength evaluation tester. Specifically, the measurement of the joining strength was measured by fixing a first member (Cu plate) of the joined body horizontally, pressing a second member (Si wafer) from the side in the horizontal direction using a shear tool at a position 50 $\mu$m above the surface (top face) of the joining layer, and then measuring the strength at the time when the second member was fractured. The moving speed of the shear tool was set to 0.1 mm/sec. The strength test was performed 3 times per one condition, and the arithmetic mean value thereof was used as the measured value of the joining strength.

(2) Fired silver film were produced using the silver pastes of Examples 15 to 33 and Comparative Examples 3 to 8. Specifically, first, each of the silver pastes of Examples 15 to 33 and Comparative Examples 3 to 8 was applied on a transparent glass substrate using a metal mask plate (hole size: 10 mm in length $\times$ 10 mm in width, thickness: 50

**EP 3 812 063 A1**

μm), and a silver paste layer was formed. Next, the silver paste layer formed on the transparent glass substrate was fired, that is, the silver paste layer was maintained at a temperature of 150°C (heating temperature) for 60 minutes (heating time), and thereby a fired silver film was produced. These fired silver films were designated as fired silver films of Examples 15 to 33 and Comparative Examples 3 to 8. The thermal diffusivities of these fired silver films were measured as follows.

(2-1) Method for measuring thermal diffusivity of the fired silver film

The thermal diffusivities of the fired silver films of Examples 15 to 33 and Comparative Examples 3 to 8 were measured by a laser flash method. Specifically, first, the temperature change T(t) on the back face of a fired silver film was measured at the time of instantaneously heating the fired silver film by uniformly irradiating the front face of the fired silver film with pulsed laser light. Next, since the temperature change T(t) on the back face of the fired silver film is represented by a one-dimensional heat conduction equation, a (T(t) - t) curve was obtained by plotting the temperature change T(t) on the back face of the fired silver film on the axis of ordinate and plotting the elapsed time t on the axis of abscissa, and the time $t_{0.5}$ required to reach a temperature equivalent to half the maximum flash temperature $T_{MAX}$ was determined from this curve. Then, the thermal diffusivity $\alpha$ of the fired silver film was determined by the following Formula (2).

$$\alpha = 1.370 \times L^2 / (\pi^2 \times t_{0.5}) \quad \ldots\ldots(2)$$

In the above Formula (2), L represents the thickness of the fired silver film. These results are presented in Tables 3 and 4.

[Table 3]

| | Silver powder | | Mixed solution | | Joining strength of joined body (MPa) | Thermal diffusivity of fired silver film (W/mK) |
| | Mixing proportion (parts by mass) | Type | Type | Mixing proportion (parts by mass) | | |
|---|---|---|---|---|---|---|
| Example 15 | 75 | No.1 | Example 1 | 25 | 38 | 122 |
| Example 16 | 80 | No.1 | Example 1 | 20 | 45 | 142 |
| Example 17 | 85 | No.1 | Example 1 | 15 | 50 | 150 |
| Example 18 | 90 | No.1 | Example 1 | 10 | 50 | 152 |
| Example 19 | 85 | No.2 | Example 1 | 15 | 40 | 127 |
| Example 20 | 85 | No.3 | Example 1 | 15 | 39 | 123 |
| Example 21 | 85 | No.4 | Example 1 | 15 | 45 | 142 |
| Example 22 | 85 | No.1 | Example 5 | 15 | 49 | 142 |
| Example 23 | 85 | No.1 | Example 6 | 15 | 48 | 145 |
| Example 24 | 85 | No.1 | Example 7 | 15 | 47 | 155 |
| Example 25 | 85 | No.1 | Example 8 | 15 | 47 | 152 |

(continued)

| | Silver powder | | Mixed solution | | Joining strength of joined body (MPa) | Thermal diffusivity of fired silver film (W/mK) |
|---|---|---|---|---|---|---|
| | Mixing proportion (parts by mass) | Type | Type | Mixing proportion (parts by mass) | | |
| Example 26 | 85 | No.1 | Example 9 | 15 | 46 | 149 |
| Example 27 | 85 | No.1 | Example 10 | 15 | 42 | 148 |
| Example 28 | 85 | No.1 | Example 11 | 15 | 46 | 144 |
| Example 29 | 85 | No. 5 | Example 1 | 15 | 43 | 132 |
| Example 30 | 85 | No.6 | Example 1 | 15 | 44 | 130 |
| Example 31 | 85 | No.1 | Example 12 | 15 | 48 | 150 |
| Example 32 | 85 | No.1 | Example 13 | 15 | 47 | 146 |
| Example 33 | 85 | No.1 | Example 14 | 15 | 46 | 145 |

[Table 4]

| | Silver powder | | Mixed solution | | Joining strength of joined body (MPa) | Thermal diffusivity of fired silver film (W/mK) |
|---|---|---|---|---|---|---|
| | Mixing proportion (parts by mass) | Type | Type | Mixing proportion (parts by mass) | | |
| Comparative Example 3 | 85 | No.1 | Comparative Example 1 | 15 | 20 | 78 |
| Comparative Example 4 | 85 | No.1 | Comparative Example 2 | 15 | Not formed into paste | |
| Comparative Example 5 | 85 | No.7 | Example 1 | 15 | 20 | 119 |
| Comparative Example 6 | 85 | No.8 | Example 1 | 15 | 10 | 80 |
| Comparative Example 7 | 85 | No.9 | Example 1 | 15 | 15 | 90 |
| Comparative Example 8 | 85 | No. 10 | Example 1 | 15 | 11 | 140 |

[Table 5]

| | First silver particles (particle size 100nm or more and less than 500nm) (volume%) | Second silver particles (particle size 50nm or more and less than 100nm) (volume%) | Third silver particles (particle size less than 50nm) (volume%) | Amount of organic material (volume%) |
|---|---|---|---|---|
| No. 1 | 80 | 17.5 | 2.5 | 0.2 |
| No. 2 | 60 | 39 | 1 | 0.3 |
| No. 3 | 94 | 5 | 1 | 0.5 |
| No. 4 | 80 | 19 | 1 | 0.5 |
| No. 5 | 56 | 39 | 5 | 0.4 |
| No. 6 | 93 | 5 | 2 | 0.5 |
| No. 7 | 94 | 1 | 5 | 0.5 |
| No. 8 | 40 | 50 | 10 | 0.5 |
| No. 9 | 60 | 33 | 7 | 0.2 |
| No. 10 | 100 | 0 | 0 | 0.3 |

As is obvious from Table 4, in a case in which a joined body and a fired silver film were produced using the silver paste of Comparative Example 3 to which a fatty acid silver salt was not added, the joining strength of the joined body was low such as 20 MPa, and the thermal diffusivity of the fired silver film was small. The diffusivity was low such as 78 W/mK. In Comparative Example 4 to which an aliphatic amine was not added, a silver paste was not obtained, and therefore, a joined body and a fired silver film could not be produced. In contrast to these, in a case in which joined bodies and fired silver films were produced using the silver pastes of Examples 15 to 33, to which silver acetate, silver oxalate, or silver myristate was added as a fatty acid silver salt, and aminodecane, hexylamine, or nonylamine was added as an aliphatic amine, the joining strength of the joined bodies was high such as 38 MPa to 50 MPa, and the thermal diffusivities of the fired silver films were high such as 122 W/mK to 155 W/mK.

In a case in which a joined body and a fired silver film were produced using the silver paste of Comparative Example 5, in which the amount of silver particles having a particle size of 50 nm or more and less than 100 nm was as small as 1% by volume, the joining strength of the joined body was low such as 20 MPa, and the thermal diffusivity of the fired silver film was low such as 119 W/mK.

In a case in which a joined body and a fired silver film were produced using the silver paste of Comparative Example 6, in which the amount of silver particles having a particle size of 50 nm or more and less than 100 nm was large such as 50% by volume and the amount of silver particles having a particle size of less than 50 nm was small such as 10% by volume, the joining strength of the joined body was low such as 10 MPa, and the thermal diffusivity of the fired silver film was low such as 80 W/mK.

In a case in which a joined body and a fired silver film were produced using the silver paste of Comparative Example 7, in which the amount of silver particles having a particle size of less than 50 nm was large such as 7% by volume, the joining strength of the joined body was low such as 15 MPa, and the thermal diffusivity of the fired silver film was low such as 90 W/mK.

In a case in which a joined body and a fired silver film were produced using, as the silver powder, the silver paste of Comparative Example 8 that included 100% by volume of silver particles having a particle size of 100 nm or more and less than 500 nm, the joining strength of the joined body was low such as 11 MPa.

As is obvious from Table 3, in a case in which joined bodies and fired silver films were produced using the silver pastes of Examples 15 to 33, which included, as the silver powder, first silver particles having a particle size of 100 nm or more and less than 500 nm in an amount ranging from 55% by volume to 95% by volume; second silver particles having a particle size of 50 nm or more and less than 100 nm in an amount range of 5% by volume or more and 40% by volume or less; and third silver particles having a particle size of less than 50 nm in an amount of 5% by volume or less, the joining strength of the joined bodies was high such as 38 MPa to 50 MPa, and the thermal diffusivities of the fired silver films were high such as 122 W/mK to 155 W/mK.

<Comparison Test 3 and evaluation>

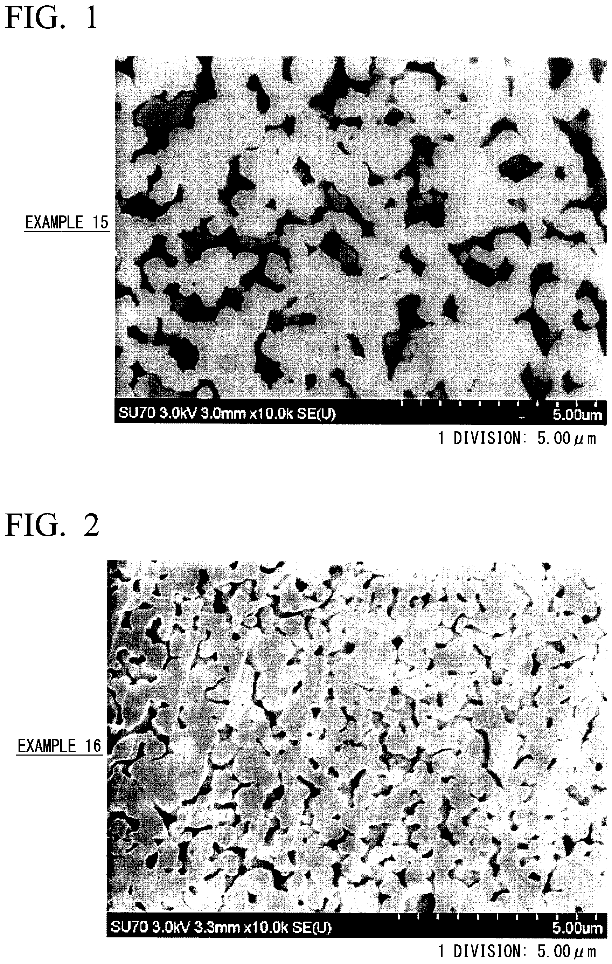

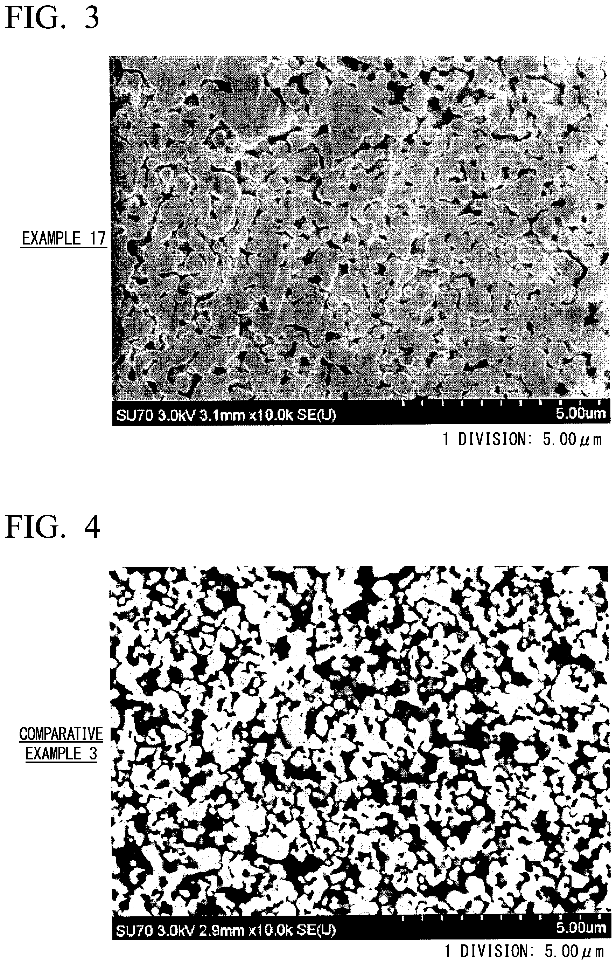

For the joined bodies of Examples 15 to 17 and Comparative Example 3, a cross section of the joining layer was observed by FE-SEM. The results are shown in Fig. 1 to Fig. 4.
As is obvious from Fig. 1 to Fig. 4, in the joined body produced using the silver paste of Comparative Example 3 (Fig. 4), in which a fatty acid silver salt was not added, many depletions (voids) were present in the joining layer, while in the joined bodies produced using the silver pastes of Examples 15 to 17 (Fig. 1 to Fig. 3), in which silver acetate was added as a fatty acid silver salt, fewer depletions were found in the joining layer. With regard to the joined bodies of Examples 15 to 17, it was found that when the amount of the silver powder was increased from 75% by mass (Example 15: Fig. 1) to 80% by mass (Example 16: Fig. 2) and was further increased to 85% by mass (Example 17: Fig. 3), the depletions in the joining layer decreased.

<Examples 34 and 35>

In the silver pastes of Examples 34 and 35, as the mixed solution and the resin, those of the types shown in Table 1 and Table 6 were used, and the silver powder, the mixed solution, and the resin were mixed at the respective proportions shown in Table 6. The resin was added when the mixed solution and the silver powder were mixed, and the resin was kneaded together with these. A silver paste was prepared in the same manner as in Example 15, except for the formulation shown in Table 6.

<Comparison Test 4 and evaluation>

Using the silver pastes of Example 17, Example 34, and Example 35, joined bodies were respectively produced in the same manner as in Comparison Test 2, and the joining strength of these joined bodies was measured in the same manner as in Comparison Test 2. Furthermore, using the silver pastes of Example 17, Example 34, and Example 35, fired silver films were respectively produced in the same manner as in Comparison Test 2, and the thermal diffusivities of these fired silver films were measured in the same manner as in Comparison Test 2. Furthermore, the joined bodies of Example 17, Example 34, and Example 35 were subjected to a cooling-heating cycle test, and then the joining strength of these joined bodies was measured in the same manner as in Comparison Test 2. The cooling/heating cycle test was carried out by using a gas phase method, in which an operation of maintaining at -40°C for 20 minutes and then maintaining at +150°C for 20 minutes was repeated for 1,000 cycles. The results are presented in Table 6 and Table 7.
In the column for the type of the resin in Table 6, "D1" indicates an epoxy-based thermosetting resin composition, and "D2" indicates a silicone-based thermosetting resin composition (both in a liquid form at room temperature, curing temperature: 140°C to 150°C). In the column for the type of the silver powder in Table 6, No. 1 is silver powder No. 1 in Table 5, and the mixed solution is the mixed solution of Example 1 in Table 1. Furthermore, in Table 6, the mixing proportion of the resin is the proportion when the amount of the silver paste was designated as 100% by mass.

[Table 6]

|  | Silver powder | | Mixed solution | | Resin | |
|---|---|---|---|---|---|---|
|  | Type | Mixing proportion (mass%) | Type | Mixing proportion (mass%) | Type | Mixing proportion (mass%) |
| Example 34 | No.1 | 85 | Example 1 | 13 | D1 | 2 |
| Example 35 | No.1 | 85 | Example 1 | 13 | D2 | 2 |
| Example 17 | No.1 | 85 | Example 1 | 15 | - | 0 |

[Table 7]

| | Joining strength of joined body | | Thermal diffusivity of fired silver film(W/mK) |
|---|---|---|---|
| | Initial (MPa) | After cooling-heating cycle test (MPa) | |
| Example 34 | 35 | 36 | 100 |
| Example 35 | 25 | 23 | 101 |
| Example 17 | 50 | 22 | 150 |

As is obvious from Table 6 and Table 7, in a case in which a joined body and a fired silver film were produced using the silver paste of Example 17, to which a resin was not added, the initial (before the cooling-heating cycle test) joining strength of the joined body was high such as 50 MPa, and the thermal diffusivity of the fired silver film was high such as 150 W/mK; however, the joining strength of the joined body after the cooling-heating cycle test became low such as 22 MPa. In contrast, in a case in which a joined body and a fired silver film were produced using the silver paste of Example 34, to which an epoxy-based thermosetting resin composition was added as the resin, the initial (before the cooling-heating cycle test) joining strength of the joined body was 35 MPa, which was lower than that of Example 17, and the thermal diffusivity of the fired silver film was 100 W/mK, which was lower than that of Example 17; however, the joining strength of the joined body after the cooling-heating cycle test was 36 MPa, which was higher than that of Example 17.

In a case in which a joined body and a fired silver film were produced using the silver paste of Example 35, to which a silicone-based thermosetting resin composition was added as the resin, the initial (before the cooling-heating cycle test) joining strength of the joined body was 25 MPa, which was lower than that of Example 17, and the thermal diffusivity of the fired silver film was 101 W/mK, which was lower than that of Example 17; however, the joining strength of the joined body after the cooling-heating cycle test was 23 MPa, which was higher than that of Example 17.

INDUSTRIAL APPLICABILITY

The silver paste of the present invention can be utilized in a joining layer for joining a circuit board and a high-power LED element, a joining layer for joining a circuit board and a power semiconductor chip, and the like, and therefore, the silver paste is industrially applicable.

**Claims**

1.  A silver paste comprising:

    a silver powder;
    a fatty acid silver salt; and
    an aliphatic amine,
    wherein the silver powder includes first silver particles having a particle size of 100 nm or more and less than 500 nm in an amount ranging from 55% by volume to 95% by volume, second silver particles having a particle size of 50 nm or more and less than 100 nm in an amount range of 5% by volume or more and 40% by volume or less, and third silver particles having a particle size of less than 50 nm in an amount of 5% by volume or less.

2.  The silver paste according to claim 1, further comprising a resin.

3.  The silver paste according to claim 1, further comprising a solvent.

4.  The silver paste according to claim 1, comprising a complex formed by a reaction between at least a portion of the fatty acid silver salt and at least a portion of the aliphatic amine.

5.  A method for producing a joined body, the method comprising:

    a step of preparing a first member and a second member;
    a step of applying the silver paste according to any one of claims 1 to 4 on a surface of at least one of the first member and the second member and thereby forming a silver paste layer;

a step of laminating the first member and the second member, with the silver paste layer interposed therebetween, and thereby producing a laminated body;

a step of heating the laminated body to sinter the first silver particles, the second silver particles, and the third silver particles in the silver paste layer, thereby forming a joining layer, and producing a joined body in which the first member and the second member are laminated, with the joining layer interposed therebetween.

FIG. 1

EXAMPLE 15

SU70 3.0kV 3.0mm x10.0k SE(U)          5.00um

1 DIVISION: 5.00 $\mu$m

FIG. 2

EXAMPLE 16

SU70 3.0kV 3.3mm x10.0k SE(U)          5.00um

1 DIVISION: 5.00 $\mu$m

## FIG. 3

EXAMPLE 17

SU70 3.0kV 3.1mm x10.0k SE(U)    5.00um

1 DIVISION: 5.00 μm

## FIG. 4

COMPARATIVE EXAMPLE 3

SU70 3.0kV 2.9mm x10.0k SE(U)    5.00um

1 DIVISION: 5.00 μm

## INTERNATIONAL SEARCH REPORT

| International application No. |
| --- |
| PCT/JP2019/024989 |

**A. CLASSIFICATION OF SUBJECT MATTER**
Int.Cl.    B22F1/00(2006.01)i,    B22F7/04(2006.01)i,    H01B1/22(2006.01)i,
H01L21/52(2006.01)i

According to International Patent Classification (IPC) or to both national classification and IPC

**B. FIELDS SEARCHED**

Minimum documentation searched (classification system followed by classification symbols)
Int.Cl. B22F1/00-B22F9/30, H01B1/22, H01L21/52

Documentation searched other than minimum documentation to the extent that such documents are included in the fields searched
| | |
| --- | --- |
| Published examined utility model applications of Japan | 1922–1996 |
| Published unexamined utility model applications of Japan | 1971–2019 |
| Registered utility model specifications of Japan | 1996–2019 |
| Published registered utility model applications of Japan | 1994–2019 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | WO 2012/133767 A1 (NAMICS CORP.) 04 October 2012, entire text, fig. 1-2 & TW 201247859 A | 1-5 |
| A | JP 2010-505230 A (EXAX INC.) 18 February 2010, entire text, fig. 1-5 & US 2010/0123102 A1, entire text, fig. 1-5 & WO 2008/093915 A1 & KR 10-0709724 B1 & CN 101523509 A | 1-5 |

☒   Further documents are listed in the continuation of Box C.            ☐   See patent family annex.

| | | |
| --- | --- | --- |
| * Special categories of cited documents: | "T" | later document published after the international filing date or priority date and not in conflict with the application but cited to understand the principle or theory underlying the invention |
| "A" document defining the general state of the art which is not considered to be of particular relevance | | |
| "E" earlier application or patent but published on or after the international filing date | "X" | document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" document referring to an oral disclosure, use, exhibition or other means | | |
| "P" document published prior to the international filing date but later than the priority date claimed | "&" | document member of the same patent family |

| Date of the actual completion of the international search | Date of mailing of the international search report |
| --- | --- |
| 06 September 2019 (06.09.2019) | 17 September 2019 (17.09.2019) |

| Name and mailing address of the ISA/ | Authorized officer |
| --- | --- |
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

**INTERNATIONAL SEARCH REPORT**

International application No.

PCT/JP2019/024989

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2015-508434 A (THE BOARD OF TRUSTEES OF THE UNIVERSITY OF ILLINOIS) 19 March 2015, entire text, fig. 1-34 & US 2015/0004325 A1, entire text, fig. 1-34 & WO 2013/096664 A1 & KR 10-2014-0106718 A | 1-5 |
| A | JP 2016-148089 A (MITSUBISHI MATERIALS CORP.) 18 August 2016, entire text, fig. 1-2 & US 2018/0033515 A1, entire text, fig. 1-2 & WO 2016/129368 A1 & EP 3257605 A1 & TW 201700405 A & CN 107206490 A & KR 10-2017-0118057 A | 1-5 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018119463 A
- JP 2019065363 A
- JP 2019114214 A
- JP 5872545 B